# EUROPEAN PATENT APPLICATION

(11) **EP 2 145 713 A2**
(43) Date of publication of application: **20.01.2010**
(21) Application number: 09290574.4
(22) Date of filing: 17.07.2009
(51) Int. Cl.: B23H 1/04, B23H 3/04, B23H 7/20

(54) **Apparatus and method for designing an electrode shape for an electrical discharge machining process**

(30) Priority: 18.07.2008 US 82067 P; 12.06.2009 US 483903
(71) Applicant: Spatial Corp., Broomfield, CO 80021 (US)
(72) Inventor: Seibold, Wolfgang, Louisville, Colorado 80027 (US); Doerstling, Brendan H., Arvada, Colorado 80005 (US); Sloan, John H., IV, Loveland, Colorado 80537 (US)
(74) Representative: Hirsch & Associés

(57) **Abstract**

A computer readable storage medium includes executable instructions to obtain an orbital path shape. Each point on the orbital path shape represents a displacement of the tool shape when the tool shape is moved along the orbital path shape. The tool shape, when moved along the orbital path shape, sweeps out a desired cavity shape. The executable instructions further include instructions to obtain an input solid model corresponding to the desired cavity shape to be swept out and derive a set of faces for a solid model of the tool shape based on the orbital path shape and a set of faces, a set of edges and a set of vertices corresponding to the input solid model. The executable instructions further include instructions to combine a subset of the set of faces derived for the tool shape to generate the solid model of the tool shape. In one embodiment, the tool shape corresponds to a Minkowski decomposition of the input solid model with respect to the orbital path shape.

## Description

### CROSS-REFERENCE TO RELATED APPLICATION

This application claims priority to U.S. Provisional Patent Application Serial Number 61/082,067, filed July 18, 2008, entitled, "Apparatus and Method for Designing An Electrode Shape For An Electrical Discharge Machining (EDM) Process", and U.S. Patent Application Serial Number 12/483,903, filed June 12, 2009, entitled, "Apparatus and Method for Designing an Electrode Shape for an Electrical Discharge Machining Process", the contents of which are incorporated herein by reference.

### FIELD OF THE INVENTION

The invention generally relates to Computer Aided Design (CAD) and more particularly to a method for designing a body shape that is swept along a path to obtain a desired shape, such as an electrode shape for an Electrical Discharge Machining (EDM) process.

### BACKGROUND

EDM is a metal-removal process that is used to remove metal by means of a series of rapidly recurring electric arcing discharges between an electrode (the cutting tool) and a work piece, in the presence of an energetic electric field. The metal-removal process is typically performed by applying a pulsating electrical charge of high-frequency current through the electrode to the work piece, while moving the electrode along an orbital path. This removes or erodes tiny pieces of metal from the work piece at a controlled rate to produce a finished work piece having a cavity of a desired shape.

A number of approaches exist to account for the orbital path shape in the design of electrodes for an EDM process. One such approach includes manually designing a CAD model corresponding to an electrode, based on a set of design rules. However, the manual design of CAD models of electrodes is time-consuming and generally prone to error. Further, the use of design rules is typically not sophisticated enough to permit human designers to create the complex tool shapes to generate complex target cavity shapes. In addition, design rules are typically not sophisticated enough to detect situations wherein an electrode tool shape for a target cavity shape may not exist.

Designing electrode shapes for an EDM process may also be performed using computer-based solutions. While computer-based solutions can be used to compute electrode shapes for certain polygonal orbital paths, an approximation of the shape of the path is typically involved for non-polygonal orbital paths. One such solution includes polygonally approximating an orbital path shape of the electrode. Approximating a smoothly curved orbit by a polygon can result in spurious sharp corners on the electrode. Further, when non-polygonal orbital paths are approximated, the electrode shape obtained typically has more faces than the original cavity model, resulting in performance and robustness issues in CAD applications that implement these approximations. As a result, desired levels of accuracies for calculating the shape of the electrode cannot be efficiently achieved.

Electrode design techniques have also been developed that modify the geometric shape of an electrode based on the application of a non-uniform offsetting technique in order to account for an orbiting motion of the electrode. These techniques typically involve approximating a target surface by performing a non-uniform offsetting of sampled points according to orbiting patterns. As with the other approximation techniques discussed above, the use of these approaches typically results in a trade-off between achieving desired levels of accuracy and desired levels of performance for electrode shape design.

It would therefore be desirable to develop an efficient and accurate technique for designing an electrode shape for an EDM process.

### SUMMARY

Embodiments of the invention relate to an apparatus and method for designing a body shape that is swept along a path to obtain a desired shape, such as an electrode shape for an EDM process. In one embodiment, a computer readable storage medium includes executable instructions to generate a solid model of a tool shape. The executable instructions include instructions to obtain an orbital path shape. Each point on the orbital path shape represents a displacement of the tool shape when the tool shape is moved along the orbital path shape. The tool shape, when moved along the orbital path shape, sweeps out a desired cavity shape. The executable instructions further include instructions to obtain an input solid model corresponding to the desired cavity shape to be swept out and derive a set of faces for the solid model of the tool shape based on the orbital path shape and a set of faces, a set of edges and a set of vertices corresponding to the input solid model. The executable instructions further include instructions to combine a subset of the set of faces derived for the solid model of the tool shape to generate the solid model of the tool shape. In one embodiment, the tool shape corresponds to a Minkowski decomposition of the input solid model with respect to the orbital path shape.

The invention refers to a computer readable storage medium comprising executable instructions to:
obtain an orbital path shape, wherein each point on the orbital path shape represents a displacement of a tool shape when the tool shape is moved along the orbital path shape, and wherein the tool shape, when moved along the orbital path shape, sweeps out a desired cavity shape;
obtain an input solid model corresponding to the desired cavity shape to be swept out;
derive a set of faces for a solid model of the tool shape based on the orbital path shape and a set of faces, a set of edges and a set of vertices corresponding to the input solid model; and
combine a subset of the set of faces derived for the solid model of the tool shape to generate the solid model of the tool shape, wherein the tool shape corresponds to a Minkowski decomposition of the input solid model with respect to the orbital path shape.

The computer readable storage medium according to the invention may comprise any one or a plurality of the followings features, alone or in combination:
- at least a subset of the set of faces is derived for the solid model of the tool shape using variable offset surface geometry defined by a solid modeler;
- the solid model of the tool shape represents a CAD model of an electrode shape;
- the computer readable storage medium further comprises executable instructions to derive a subset of the set of faces for the solid model of the tool shape corresponding to a subset of the set of faces in the input solid model by convoluting a subset of the geometry associated with the set of faces in the input solid model with a subset of the orbital path shape;
- the computer readable storage medium further comprises executable instructions to derive a subset of the set of faces for the solid model of the tool shape corresponding to a subset of the set of edges in the input solid model by convoluting a subset of the geometry associated with the set of edges in the input solid model with a subset of the orbital path shape;
- the computer readable storage medium further comprises executable instructions to derive a subset of the set of faces for the solid model of the tool shape corresponding to a subset of the set of vertices in the input solid model by convoluting a subset of the geometry associated with the set of vertices in the input solid model with a subset of the orbital path shape;
- each point on the convolution of each face in the input solid model with the orbital path shape that lies on the boundary of the Minkowski decomposition is included in the set of faces corresponding to the solid model of the tool shape;
- the executable instructions to obtain the orbital path shape comprise executable instructions to analyze the orbital path shape to identify regions in the orbital path shape that correspond to a set of exceptional features and a set of silhouette features on the boundary of the input solid model;
- the computer readable storage medium further comprises executable instructions to use the set of exceptional features and the set of silhouette features to partition the boundary of the input solid model into one or more strips, wherein the strips correspond to the regions in the orbital path shape;
- the executable instructions to generate the solid model of the tool shape further comprise executable instructions to map the strips in the input solid model to corresponding strips in the solid model of the tool shape;
- the computer readable storage medium further comprises executable instructions to identify exceptional points in the input solid model and replace the exceptional points with corresponding parameterized faces;
- the computer readable storage medium further comprises executable instructions to repair the solid model of the tool shape;
- the executable instructions to repair the solid model of the tool shape comprise executable instructions to detect and remove sets of coincident exceptional faces and sets of coincident silhouette faces from the solid model of the tool shape;
- the executable instructions to repair the solid model of the tool shape further comprise executable instructions to detect a set of zero-area faces and zero-length edges in the solid model of the tool shape and replace the set of zero-area faces and zero-length edges with a set of edges and vertices;
- the executable instructions to repair the solid model of the tool shape further comprise executable instructions to detect and remove duplicates within sets of coincident faces, coincident edges and coincident vertices from the solid model of the tool shape;
- the executable instructions to repair the solid model of the tool shape further comprise executable instructions to detect and remove self-intersections in the solid model of the tool shape;
- the computer readable storage medium further comprises executable instructions to provide a notification of manufacturability of the solid model of the tool shape to a user.
- the orbital path shape is a planar orbital path shape;
- the orbital path shape is a circular orbital path shape; and
- the surface associated with at least one face in the set of faces for the solid model of the tool shape uses more than one branch to define its shape.
   According to an embodiment of the computer readable storage medium of the invention, the solid model of the tool shape is an intermediate model of the tool shape. Preferably, the computer readable storage medium further comprises executable instructions to perform a plurality of solid modeling operations on the intermediate model of the tool shape to generate a final solid model of the tool shape. More preferably, the plurality of solid modeling operations comprise executable instructions to process the intermediate solid model of the tool shape to compensate for spark gap effects.

### BRIEF DESCRIPTION OF THE FIGURES

Certain embodiments of the invention are more fully appreciated in connection with the following detailed description taken in conjunction with the accompanying drawings, in which:
Fig. 1 illustrates a computer configured in accordance with one embodiment of the present invention.
Fig. 2 is a flowchart illustrating processing operations for automatically generating an electrode shape for an EDM process, in accordance with one embodiment of the present invention.
Fig. 3 illustrates exemplary shapes corresponding to an orbital path for an EDM process, in accordance with one embodiment of the present invention.
Fig. 4 illustrates a closed, planar curve describing an orbital path for an EDM process, in accordance with one embodiment of the present invention.
Fig. 5 illustrates a linear region in a curve having inflection points, wherein the curve is split into regions of fixed convexity, in accordance with one embodiment of the present invention.
Fig. 6(a) illustrates a curve with at most two points with parallel or anti-parallel tangent vectors in any direction, in accordance with one embodiment of the present invention.
Fig. 6(b) illustrates a curve with more than two points with parallel or anti-parallel tangent vectors in a particular direction, in accordance with one embodiment of the present invention.
Fig. 7 illustrates a curve with a turning angle greater than two pi, no inflection points and more than two points with parallel or anti-parallel tangent vectors in a particular direction, in accordance with one embodiment of the present invention.
Fig 8 illustrates a curve with potential displacement vectors for a point with a surface normal in the vertical direction, in accordance with one embodiment of the present invention.
Fig. 9 illustrates tangent vectors associated with a sharp corner point in a curve, in accordance with one embodiment of the present invention.
Fig. 10 is a cross-section of a solid model that illustrates multiple surface normals associated with a sharp edge on the boundary of the model, in accordance with one embodiment of the present invention.
Fig. 11 is a cross-section of a solid model that illustrates convex and concave edges on the boundary of the model, in accordance with one embodiment of the present invention.
Fig. 12 illustrates an exceptional curve for a horizontal torus, in accordance with one embodiment of the present invention.
Fig. 13 illustrates silhouette directions caused by inflection points, separating a curve into regions, and a linear region, in accordance with one embodiment of the present invention.
Fig. 14 is a cross-section of a solid model that illustrates a segregation of the model into vertical strips, in accordance with one embodiment of the present invention.
Fig. 15 illustrates a cross-section of the set of strips formed by adjusting copies of the strips in Fig. 14 by corresponding regions of the curve in Fig. 13, in accordance with one embodiment of the present invention.
Fig. 16 illustrates cross-sections of solid models that illustrate a mapping of a strip on an original model into a strip on an offset model, in accordance with another embodiment of the present invention.
Fig. 17 illustrates cross-sections of solid models that illustrate silhouette faces generated by silhouette edges when translating a triangular (vertical) prism along a square orbital path, in accordance with one embodiment of the present invention.
Fig. 18 illustrates performing offsetting operations to various branches of an orbital path shape, in accordance with one embodiment of the present invention.
Fig. 19 illustrates a parameter-space depiction of inward and outward branches for ½ faced cylinders, in accordance with one embodiment of the present invention.
Fig. 20 illustrates a cross-section of a solid model that translates a cylinder into left and right directions within an orbital plane, corresponding to two branches of a circular path, in accordance with one embodiment of the present invention.

### DETAILED DESCRIPTION

Various features associated with the operation of embodiments of the present invention will now be set forth. Prior to such description, a glossary of terms applicable for some embodiments is provided.

**Boolean complement:** According to some embodiments, the Boolean complement of a set of points in a space is defined as all the points in the space which are not part of the set. For example, the Boolean complement of a solid sphere is the set of points surrounding a spherical cavity with the same center and radius as the sphere.

**Solid:** According to some embodiments, a solid is a set of points in three-dimensional space meant to represent a physical shape.

**Boundary of a solid:** According to some embodiments, the boundary of a solid is the set of points that separate the interior of a solid from its exterior. In the case of infinitesimally thin two-dimensional (sheet), one-dimensional (wire), or zero-dimensional (point) solids, a solid forms its own boundary.

**Boundary representation:** According to some embodiments, the boundary representation is a technique for representing the shape of a solid through the properties (e.g. shape, connectivity) of its boundary.

**B-Rep solid model:** According to some embodiments, the B-rep solid model is data which specifies the shape of a solid using the technique of boundary representation.

**Offset outwards:** According to some embodiments, offset outwards is defined as adding a layer of material around the boundary of a solid, thereby creating a new, larger, solid of a similar shape.

**Offset inwards:** According to some embodiments, offset inwards is defined as removing a layer of material around the boundary of a solid, thereby creating a new, smaller, solid of similar shape.

**Surface:** According to some embodiments, a surface is a two-dimensional connected set of points in a three-dimensional space, typically parameterized through a 1-to-1 mapping into a rectangle in a flat two-dimensional space.

**Curve:** According to some embodiments, a curve is a one-dimensional connected set of points in a three-dimensional space, typically parameterized through a 1-to-1 mapping into a line segment in a flat one-dimensional space.

**Face:** According to some embodiments, a face is a two-dimensional element of the boundary of a solid model. The geometry of a particular face is typically defined as a connected two-dimensional subset of a particular surface on the boundary of the solid model. Adjacent faces are typically separated by a collection of edges and/or vertices.

**Edge:** According to some embodiments, an edge is a one-dimensional element of the boundary of a solid model. The geometry of a particular edge is typically defined as a connected one-dimensional subset of a particular curve on the boundary of the solid model. Adjacent edges are typically separated by vertices.

**Vertex:** According to some embodiments, a vertex is a zero-dimensional element of the boundary of a solid model. The geometry of a particular vertex is typically defined as a particular point on the boundary of the solid model.

**Exceptional point:** According to some embodiments, an exceptional point is a point on the boundary of a solid for which the condition that the surface normal at that point is perpendicular to the orbital plane is satisfied.

**Non-exceptional point:** According to some embodiments, a non-exceptional point is a point on the boundary of a solid which is not an exceptional point.

**Exceptional region:** According to some embodiments, an exceptional region is a two-dimensional connected set of exceptional points.

**Exceptional curve:** According to some embodiments, an exceptional curve is a one-dimensional connected set of exceptional points.

**Isolated exceptional point:** According to some embodiments, an isolated exceptional point is an exceptional point which is not adjacent to any other exceptional point; for example, it is equivalent to a zero-dimensional connected set of exceptional points, where the set has only one element.

**Exceptional face:** According to some embodiments, an exceptional face is a face which is associated with an exceptional region.

**Exceptional edge:** According to some embodiments, an exceptional edge is an edge which is associated with an exceptional curve.

**Exceptional vertex:** According to some embodiments, an exceptional vertex is a vertex which is associated with an isolated exceptional point.

**Tangent manifold:** According to some embodiments, the tangent manifold is a flat space generated by those vectors tangent to a manifold at a point on that manifold. The tangent manifold to a two-dimensional surface is a plane, the tangent manifold to a one-dimensional curve is a straight line and the tangent manifold to a zero-dimensional point is empty. Two tangent manifolds are said to be parallel if the generators of one can be expressed as a linear combination of the generators of the other. In accordance with an embodiment of the present invention, the tangent manifold of a zero-dimensional point is considered parallel to any other tangent manifold.

**Silhouette direction:** According to some embodiments, a silhouette direction is a special direction in three-dimensional space which is obtained through analysis of an orbital path.

**Silhouette point:** According to some embodiments, a silhouette point is a point on the boundary of a solid whose tangent manifold is parallel to a silhouette direction.

**Silhouette region:** According to some embodiments, a silhouette region is a two-dimensional connected set of silhouette points.

**Silhouette curve:** According to some embodiments, a silhouette curve is a one-dimensional connected set of silhouette points. For example, the terminator circle on the earth which separates day and night regions is an example of a silhouette curve, where the silhouette direction is in the direction from the sun to the earth.

**Isolated silhouette point:** According to some embodiments, an isolated silhouette point is a silhouette point which is not adjacent to any other silhouette point; for example, it is equivalent to a zero-dimensional connected set of silhouette points, where the set has only one element.

**Sharp edge:** According to some embodiments, a sharp edge is an edge whose adjacent faces are not tangent, that is, for which the surface normals are not parallel, along the edge.

**Expanding Edge:** According to some embodiments, an expanding edge is a sharp edge for which the boundaries of the adjacent faces diverge when offsetting in a particular direction. When offsetting outwards, convex edges are expanding; when offsetting inwards, concave edges are expanding.

**Contracting Edge:** According to some embodiments, a contracting edge is a sharp edge for which the boundaries of the adjacent faces converge when offsetting in a particular direction. When offsetting outwards, concave edges are contracting, when offsetting inwards, convex edges are contracting.

**Minkowski sum:** According to some embodiments, for two point-sets A and B, the Minkowski sum is defined as the set of all points swept out by moving B to every point in A.

**Convolution:** According to some embodiments, the convolution of two point-sets (e.g. two surfaces, a surface and a curve, etc) is the boundary of their Minkowski sum.

**Subset:** According to some embodiments, for two elements, A and B, B is a subset of A if every element of B is also an element of A. Note that A may also be a subset of itself.

**Branch:** According to some embodiments, a branch is a region of a curve defining an orbital path which corresponds to a particular strip on the boundary of an original model.

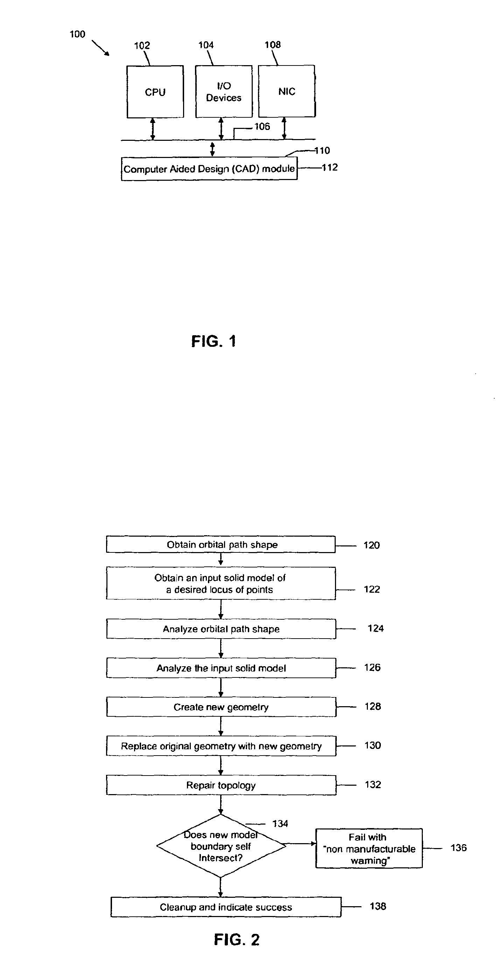

Fig. 1 illustrates a computer 100 configured in accordance with one embodiment of the present invention. The computer 100 includes various components, including a Central Processing Unit (CPU) 102 and input/output devices 104, which are linked by a bus 106. In certain embodiments, a Network Interface Circuit (NIC) 108 provides connectivity to a network (not shown), thereby allowing the computer 100 to operate in a networked environment.

A memory 110 is also connected to the bus 106. The memory 110 includes one or more executable modules to implement operations described herein. In one embodiment, the memory 110 includes a Computer Aided Design (CAD) module 112. In one embodiment, the CAD module 112 includes an ACIS Geometric Modeler which is commercially available from Spatial Corporation, Broomfield, Colo. In a particular embodiment, the CAD Module 112 also includes executable instructions to automatically generate the shape of an electrode for an EDM process. The operations performed by the CAD module 112 are discussed in greater detail in Fig. 2 below.

It should be noted that the CAD module 112 is provided by way of example. Additional modules, such as an operating system or graphical user interface module may also be included. It should be appreciated that the functions of the modules may be combined. In addition, the functions of the modules need not be performed on a single machine. Instead, the functions may be distributed across a network, if desired. Indeed, certain embodiments of the invention are implemented in a client-server environment with various components being implemented at the client-side and/or server-side.

Fig. 2 is a flowchart illustrating processing operations for generating a solid model of a tool shape, in accordance with one embodiment of the invention. In one embodiment, the solid model of the tool shape represents a CAD model of an EDM electrode shape. In a particular embodiment, one or more sub-modules in the CAD module 112 include executable instructions to generate the solid model of the tool shape. An exemplary set of operations (120-138) for generating a solid model of a tool shape are discussed in detail below.

### Operation of obtaining an orbital path shape

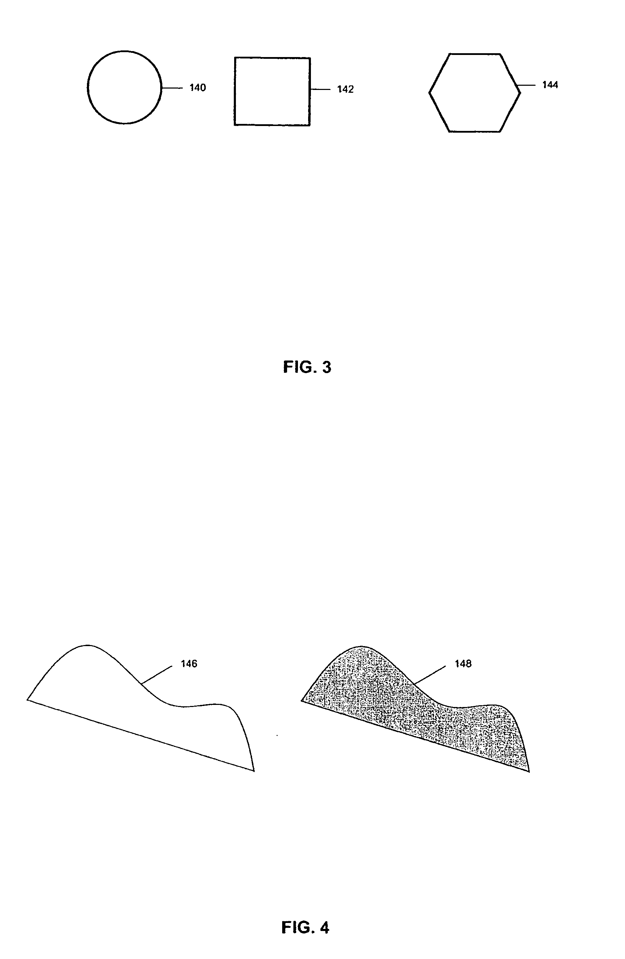

An operation to obtain an orbital path shape corresponding to the tool shape is initially performed (block 120). In one embodiment, a user specifies the orbital path shape. For example, the user may be presented with a set of pre-defined shapes, such as, for example, a "circle" 140, a "square" 142, or a "regular N-gon" 144, as illustrated in Fig. 3. The user may then select or specify parameters, such as a "radius" for a circle or an "N" "side length" and "rotational angle" for a regular N-gon. In general, the orbital path shape can be any polygonal shape or any non-polygonal shape.

In another embodiment, the user may specify a closed, planar curve describing the orbital path, as illustrated in Fig. 4. The curve may represent the actual orbital path or the boundary of a planar region corresponding to the orbital path. For example, the user may specify the closed, planar curve through a CAD modeler interface. In certain embodiments, the user may specify an orientation of (for example, the normal to) the orbital path and whether the orbital path is "filled" 148 (for which the actual path is a planar region of which the specified curve is the boundary) or "unfilled" 146 (for which the actual path is the specified curve). Specifically, each point on the orbital path shape represents a displacement of the tool shape during a motion of the tool shape along the orbital path shape. As will be discussed in greater detail below, the tool shape, when moved along the orbital path shape, sweeps out a desired cavity shape.

### Operation of obtaining an input solid model corresponding to the desired cavity shape

An operation to obtain an input solid model of a desired locus of points corresponding to the desired cavity shape to be swept out is then performed (block 122). In one embodiment, the input solid model is an input CAD model of the material to be removed. In a particular embodiment, the input CAD model of the material to be removed is a model of the unadjusted shape of the electrode (that is, the shape of the part which would be obtained by filling the desired cavity shape in the work piece with material). In another embodiment, the input CAD model of the material to be removed is a model of the shape of the cavity itself, that is, the Boolean complement of the unadjusted shape of the electrode.

### Operation of analyzing the orbital path shape

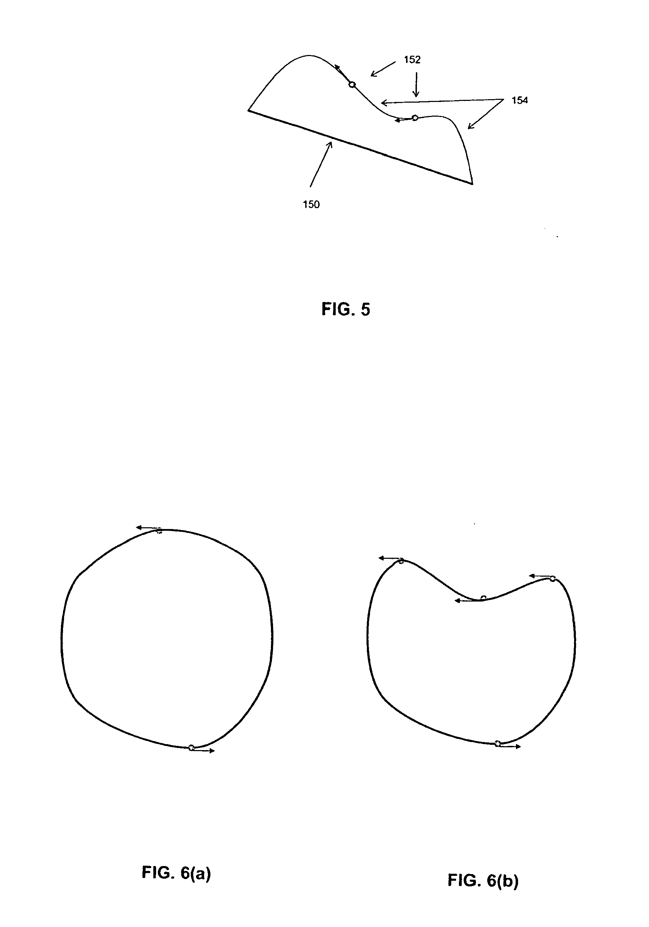

An operation to analyze the orbital path shape is then performed (block 124). In one embodiment, the orbital path shape is analyzed to identify regions of the path that correspond to loci of points on the boundary of the input solid model. In a particular embodiment, the analysis of the orbital path shape includes partitioning the orbital path shape into a set of regions. Fig. 5 illustrates an orbital path shape having a linear region. In the illustrated example, the orbital path is described by a closed planar curve with a linear region 150 and two inflection points 152. As used herein, an "inflection point" refers to a point with zero curvature. Specifically, the orbital path shape is split into regions of fixed convexity 154 with a turning angle of less than or equal to 2 pi. Splitting the orbital path shape into regions of fixed convexity and identifying inflection points enables a one-to-one mapping between the set of points on the boundary of the input solid model to a set of points on the boundary of the solid model of the tool shape (i.e., the CAD model of the electrode shape).

Note that non-linear regions having more than two points with parallel or anti-parallel tangents to the closed planar curve result in regions on the boundary of the input solid model that map to multiple regions on the boundary of the CAD model of the electrode shape. Also note that regions of fixed convexity with a total integrated turning angle of less than or equal to two pi will have no more than two interior points with parallel or anti-parallel tangents in any particular direction.

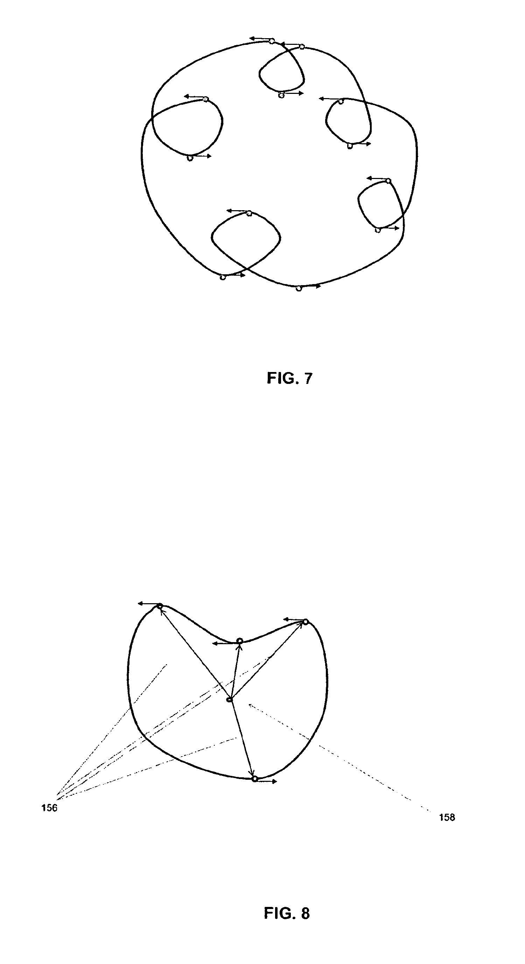

Fig. 6(a) illustrates a curve having at most two points with parallel or anti-parallel tangent vectors in any direction. Fig. 6(b) illustrates a curve with more than two points with parallel or anti-parallel tangent vectors in a particular direction. Fig. 7 illustrates a curve with a turning angle greater than 2 pi, no inflection points and more than two points with parallel or anti-parallel tangent vectors in a particular direction.

In one embodiment, a particular point on the boundary of the input CAD model is mapped into one or more points on the boundary of the CAD model of the electrode shape such that the difference between a particular offset point in the CAD model of the electrode shape and the corresponding original point in the input CAD model is the displacement vector for a point on the curve which defines the orbital path, where the tangent vector to the curve at the point on the curve is perpendicular to the surface normal at the point on the boundary of the input CAD model. Fig. 8 illustrates a curve with potential displacement vectors for a particular point on the boundary of the input CAD model where the surface normal is parallel to the horizontal direction. The origin 158 and the displacement vectors 156 for this point are illustrated. Note that for non-exceptional points on the boundary of the input CAD model and a circular orbit, there are two such points, corresponding to the ends of the circle's diagonal in the direction of the projection of the surface normal into the plane. In such a case of multiple displacements, a separate copy of the surface in the input solid CAD model is made for each displacement, and each copy is transformed by a different displacement.

In a particular embodiment, the analysis of the orbital path shape (block 124) is performed as follows.

Linear regions of the curve and the direction of the unit tangent in each linear region are identified.

Inflection points (that is, points outside the linear regions where the derivative along the curve of the unit tangent is zero or null) and the direction of the unit tangent at each inflection point are identified.

A set of unit tangent vectors is associated with each point on the curve. At "corners" of the orbital path shape (i.e., points where the path is not G1 continuous), this set includes all the unit tangents of an infinitesimal circular arc connecting the curve to the left of the discontinuity with the curve to the right of the discontinuity. As will be appreciated by those skilled in the art, a surface S can be referred to as G1 continuous at a point s if there is a single-valued, continuous function which defines the normal vector in the vicinity of s. If S is not G1 at s, then the normal vector (and hence the tangent plane) is multi-valued at that point. For example, an infinitely thin hollow sphere is G1 everywhere, an infinitely thin hollow cube is not G1 along the twelve edges and eight corners, and an infinitely thin hollow cone is not G 1 at its apex. Similarly for curves, a curve is G 1 if its tangent vector (which is perpendicular to the normal plane) is continuous. A non-G1 discontinuity is often called a "sharp" discontinuity, because it can be thought of as a region of infinite curvature in one or more directions.

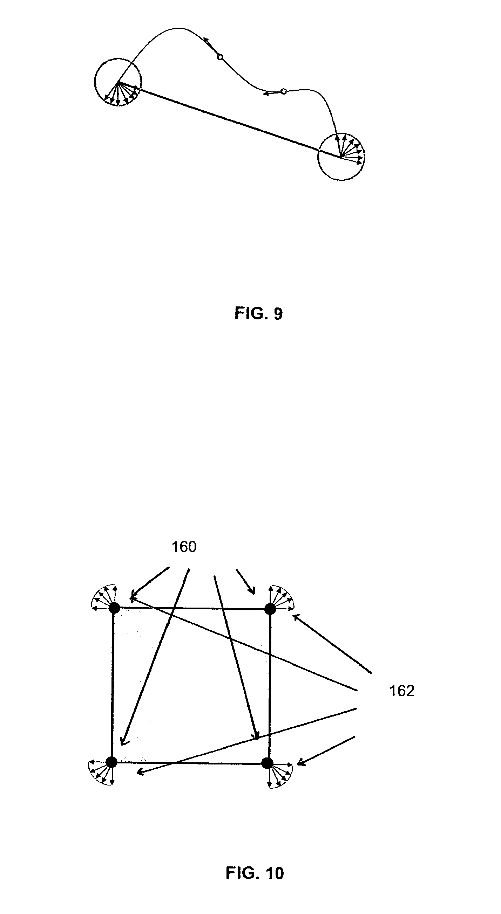

Fig. 9 illustrates tangent vectors associated with a sharp corner point in a curve. At points where the path is G 1 continuous, the set consists of the unit tangent to the curve.

The association between points on the curve and the unit tangent vectors is inverted to obtain a set of points on the curve associated with each unit tangent vector. In the case of a circular path there are two points associated with each unit tangent vector, defined by the two points at the ends of the diagonal perpendicular to the tangent. In the case of a polygonal path, one or more corners of the polygon are associated with each unit tangent which is not parallel or anti-parallel to one of the sides of the polygon.

The inverse association between unit tangent vectors and sets of boundary points is analyzed to identify "silhouette" directions in the curve. In one embodiment, the set of silhouette directions is the union of the unit tangents of the linear regions of the curve and the unit tangents of the inflection points. Note that if the curve has a winding number greater than one, and there are no linear regions or inflection points, then the set of silhouette directions is defined to be a single unit tangent vector which may be arbitrarily chosen and treated as an inflection point. This construction is typically not needed if the curve is non-self intersecting and has no inflection points. Note that a single silhouette direction typically ensures that no region of the curve will have a winding number greater than one.

The operations of obtaining an orbital path shape for electrode motion (block 120) and analyzing the orbital path shape (block 124) discussed above may be performed at any time prior to obtaining the results of the analysis. In one embodiment, the analysis of the orbital path may be performed at the time of application development for a pre-determined set of orbital path shapes. In another embodiment, the operations 120 and 124 may executed by a set of analysis routines, such as one or more sub-modules in the CAD module 112, at run time. In certain embodiments, a portion of the analysis of the orbital path may be performed at the time of application development and the remaining portion of the analysis may be performed at the time of execution of the results of the analysis.

### Operation of analyzing the input solid model

An operation to analyze the input solid model is then performed (block 126). In one embodiment, analyzing the input solid model (i.e., the input CAD model) includes deriving a set of faces for the solid model of the tool shape (that is, the output CAD model of the electrode shape) based on the orbital path shape and a set of faces, a set of edges and a set of vertices corresponding to the input CAD model. A subset of the set of faces is then combined to generate the solid model of the tool shape. In one embodiment, the tool shape corresponds to a Minkowski decomposition of the input CAD model with respect to the orbital path shape.

### Discussion of Minkowski decomposition

As will be appreciated by those skilled in the art, the locus of points swept out by an object's translational motion is related to a mathematical construction called the "Minkowski Sum". The Minkowski Sum of two point-sets A and B is defined as the set of points displaced from the origin by the vector a+b, where a is a displacement in A and b is a displacement in B. The operation to compute the Minkowski Sum of two point-sets A and B is referred as "Minkowski Addition". The locus of points swept out by an object's motion is therefore the Minkowski Sum of the object's shape T and the path of the motion P, wherein the swept shape S = T+P.

The inverse problem corresponding to Minkowski Addition is generally referred to as "Minkowski Decomposition". A Minkowski Decomposition determines for a given point-set C, a pair of point-sets A and B for which the Minkowski sum A+B is equal to C. In machining processes, the desired shape S and either the tool shape T or the path P is typically given, while the corresponding path P or tool shape T is to be calculated. For the case where T is given, a Minkowski Decomposition can be performed by finding the point-set defined by the set of all displacements p = s - t, where p, s, and t are displacements in P, S, and T, respectively. For the case where P is given, a Minkowski Decomposition is t = s - p. This form of Minkowski Decomposition, where one of the decomposed sets is known, is referred to as "Minkowski Subtraction", and can be expressed in terms of a Minkowski Sum, as discussed below.

A Minkowski Subtraction may be typically performed by defining the Boolean complement of a point-set. The Boolean complement !A of the point-set A refers to those points which are not members of A. For example, if A is a spherical solid of radius r centered at the origin, then !A is the corresponding spherical cavity of radius r centered at the origin, and vice-versa. Similarly, the reflection through the origin of a point-set is defined as follows. If (-A) is the reflection through the origin of A, then for every displacement a in A, there is a corresponding displacement -a in (-A), and vice-versa.

Based on the above, it can be shown that if T = S-P (Minkowski Subtraction), then !T = !S + (-P) (Minkowski Addition). This means that S-P is NOT equal to S+(-P), rather T = S-P = !(!S+(-P)). In terms of swept volumes, the material surrounding the cavity corresponding to the tool shape T can be found by moving the material surrounding the cavity corresponding to the shape S along a path (-P).

It should be noted that Minkowski Decomposition may not be a unique procedure, even if one of the decomposed point-sets is known. In particular, for given point-sets C and A, there might exist infinitely many point-sets B such that A+B = C. Typically, the possible solution sets B will be differentiated by changes in shape that affect only points in the interior of the sum set C, i.e. they correspond to changes in B that are "washed out" by the sum with A. It should also be noted that for particular point-sets C and A, there might not exist a point-set B such that A+B=C. In other words, C cannot always be decomposed relative to A. This is relevant in machining processes when the desired shape S cannot be decomposed relative to the tool shape T or the path P, in which case the shape is non-manufacturable by the particular machining process using the particular tool shape or path, respectively.

In addition, the computation of Minkowski Sums of point-sets representing solids can be implemented for B-Rep modelers by the computation of Minkowski Sums of the boundaries of those solids. As will be appreciated by those skilled in the art, the "Boundary Representation", or B-Rep method refers to a method of representing solids in CAD systems. This technique is based on representing the points on the "inside" of a three dimensional solid based on the two dimensional boundary of that solid, along with the outward normal of the boundary. In terms of calculating the Minkowski sum in a B-Rep modeler, the Minkowski sums of boundaries may be defined as follows. If Bnd(A) is defined as the boundary of the point-set A (where the boundary of an infinitesimally thin point-set such as a tool path is defined to be the point-set itself), then Bnd(A) is itself a point-set, and Bnd(A+B) is a subset of Bnd(Bnd(A)+Bnd(B))

In other words, the Minkowski sum of a B-Rep model and a tool path may be computed based on computing the boundary of the Minkowski sum of the boundary of the model with the boundary of the tool path and then interpreting the boundary as the boundary of the sum, removing those parts of the boundary which lie in the interior of the resulting model. For example, Bnd(A) and Bnd(B) typically refer to a collection of surfaces, curves and points, and the boundary of the Minkowski sum of two surfaces S 1 and S2 is typically referred to as the convolution of S1 and S2 and can be defined as S1*S2 = Bnd(S1+S2). The convolution of a surface with a curve or of two curves may similarly be defined. The convolution of a point with a surface, curve or point is defined as a translation of the object being convoluted with the point. Accordingly, the boundary of the Minkowski sum A+B may be expressed in terms of the convolution of the boundaries, wherein, Bnd(A+B) is a subset of Bnd(A)*Bnd(B).

A property of the convolution, A*B, of two point-sets A and B is that it will be a subset of the set C of all points c = a+b, where a is an element of A, b is an element of B, and the tangent manifold of A at a is parallel to the tangent manifold of B at b. This can be understood by interpreting A*B as the boundary of the envelope of the set of points swept out by moving A along B (or B along A). When A is positioned at a particular location b in B, any point a on the boundary of A whose tangent manifold is not parallel to that of b will correspond to a point c=a+b on the interior of the envelope after an infinitesimal motion of A to a new location b' in B near b; therefore only combinations of a and b whose tangent manifolds are parallel can appear in the boundary of the envelope, and hence can be elements of the convolution. Observe now that the calculation of the Minkowski sum can be decomposed into identifying pairs of points, a and b, on the boundaries of A and B, respectively, whose tangent manifolds are parallel; the sums of such points' displacements define points which potentially lie on the boundary of the Minkowski sum. In accordance with embodiments of the present invention, analysis routines in the CAD module 112 include executable instructions to calculate the Minkowski sum by automatically identifying one or more pairs of such points.

A further condition on the identification of such pairs of points can be obtained by recalling that the boundary of the Minkowski sum of two sets A and B, Bnd(A+B), is a subset of the convolution of the boundaries of A and B, Bnd(A)*Bnd(B). When both Bnd(A) and Bnd(B) are proper boundaries, that is there exist "interior" points of A and B which are not elements of Bnd(A) or Bnd(B), respectively, then there typically are two connected components of the convolution Bnd(A)*Bnd(B). These two components can be characterized by examining the "outward" (away from the interior) normals at identified points a in Bnd(A) and b in Bnd(B); typically one component will have a positive dot product between normals while the other will have a negative dot product between normals. When offsetting outwards, the negative component will typically be wholly on the interior of the Minkowski sum A+B and so can be discarded; similarly the positive component can typically be discarded when shelling inwards. In accordance with embodiments of the present invention, this stronger correspondence between the identified points a and b is referred to as a "directed" correspondence, which can be either "parallel" or "anti-parallel" based on the characterization of the component in which a+b is contained. As mentioned above, analysis routines in the CAD module 112 include executable instructions to calculate the Minkowski sum by automatically identifying one or more pairs of such points.

As will be appreciated by those skilled in the art, sharp discontinuities are one source of complexity when calculating the convolution of two objects (surfaces or curves), since the tangent manifold is not single-valued at the points of discontinuity. The conceptual solution is to regulate the infinite curvature by treating a discontinuous surface as the limit of a set of surfaces with large but finite curvature in the vicinity of the singularity. In terms of calculating the convolution, this implies that a particular point on a sharp discontinuity of one surface will typically correspond to one or more regions (as opposed to points) on the other surface. This implies that additional faces will typically be added to the convolution to represent this elevation in dimension. In accordance with some embodiments of the present invention, this is implemented by performing a zero-radius fillet on any sharp discontinuities to introduce the appropriate additional faces.

### Detailed discussion of the operation of analyzing the input solid model

Returning to the discussion of performing the operation 126 of analyzing the input CAD model, in one embodiment, discontinuities in the input CAD model are identified by associating the topology with "sharp" edges and corners, such as the edges and vertices of a cube. Non-G1 features on the input CAD model boundary typically have multiple surface normals associated with them and so may correspond to regions on the output CAD model boundary, when performing a Minkowski sum offset. This is generally the case for convex edges and vertices when shelling outward and concave edges and vertices when shelling inwards, where "convex" or "concave" in this context refers to the angle between the face normals adjacent to the edge or vertex. As used herein, a "Minkowski sum offset", also referred to as "rolling-ball offset", refers to an offsetting operation where the offset model represents the set of points swept out by moving the body along the path. For a constant offset operation (corresponding to a spherical path) this results in sharp edges being replaced by faces with circular cross sections, while sharp vertices are replaced by spherical faces. In contrast, and as will be appreciated by those skilled in the art, a CAD offset extends the surfaces adjacent to sharp edges and vertices and re-intersects them to obtain new sharp edges and vertices on the offset model.

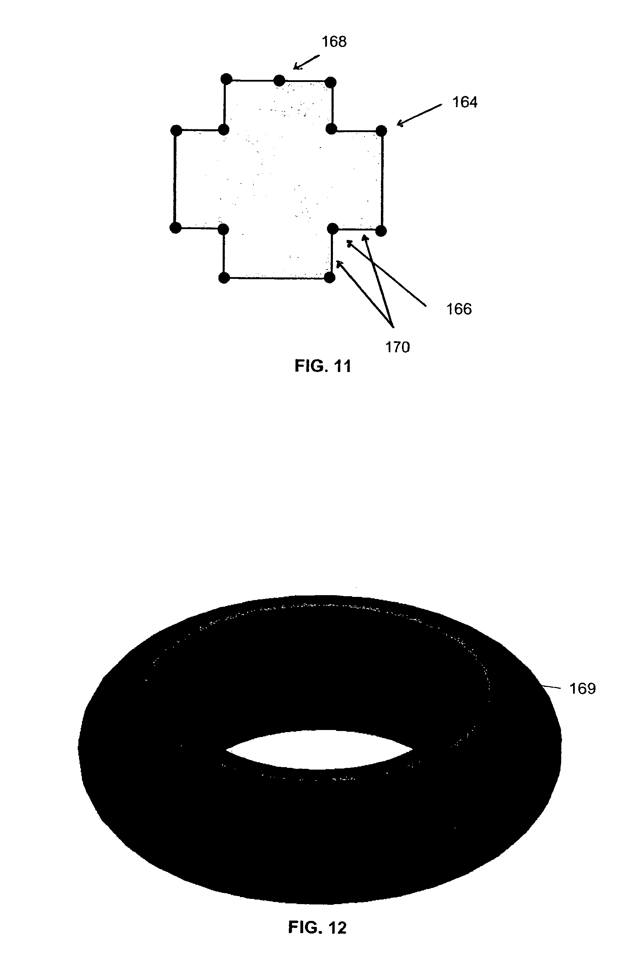

Fig. 10 illustrates, in cross-section, multiple surface normals associated with a sharp edge on the boundary of a model. If the surface normals 162 are diverging, then the sharp edge 160 is referred to a convex edge. On the other hand, if the surface normals are converging, then the sharp edge is referred to as a concave edge. Fig. 11 illustrates a convex edge 164 and a concave edge 166 on the boundary of a model. When offsetting outwards, convex edges are referred to as "expanding" edges, herein, while concave edges are referred to as "contracting" edges. When offsetting inwards, convex edges are referred to as "contracting" edges and concave edges as "expanding" edges. Fig. 11 also illustrates, in cross-section, a tangent edge 168 and a set of faces 170 neighboring the concave edge 166.

In a particular embodiment, the operation 126 of analyzing the input CAD model includes representing the new regions on the output CAD model by introducing new faces. So for every sharp feature on the input CAD model, one or more new faces with geometry corresponding to a zero-radius rolling-ball offset are introduced. Since the "expanding" classification generally depends on convexity across the edge, the mixed edges in the input CAD model are split into edges of definite convexity (convex, tangent, or concave). If there are sharp features which are "contracting" (similar to "expanding", but with convexities reversed), then they indicate features in the model which generally cannot be machined due to the orbital motion. In one embodiment, the end user is notified if a non-manufacturability warning has been requested. In some embodiments, and as will be discussed in greater detail below, geometric analysis can also be performed during the operation of analyzing the input solid model to detect non-manufacturable parts by searching for geometric configurations which result in self-intersecting offset surface geometries.

Note that, in the context of EDM electrodes, the electrode shape obtained by offsetting inwards corresponds to including the maximum amount of material. Additional material can be removed from the electrode, as long as the volume swept out by moving the electrode along the orbital path is not changed. The criteria for this is basically twofold - the removal of material typically cannot induce a void in the interior of the electrode, and the removal of material typically cannot remove any region of the boundary of the electrode (the offset model) that maps into a finite-area region of the desired shape (the original model). For example, in the context of expanding sharp edges when shelling inwards, a standard CAD offsetting technique where the adjacent surfaces are extended and re-intersected may be used to represent the region of the offset model associated with the edge. This is in contrast with techniques of adding a face corresponding to the edge, wherein the face's geometry corresponds to the Minkowski sum of the shape of the edge with the path.

In addition, for a planar orbital path, points on the input CAD model for which the surface normal is perpendicular to the orbital plane (that is, the tangent to the path is perpendicular to the normal) are special since they correspond to all the points in the path. Such points are referred to herein as "exceptional" points, and the set of all exceptional points on the boundary of the input CAD model is a collection of arbitrary numbers of isolated points (exceptional points), 1D curves (exceptional curves) and 2D regions (exceptional regions). A torus whose axis is perpendicular to the orbital plane has two exceptional curves: the flat circles at the top and bottom of the torus.

Fig. 12 illustrates a top exceptional curve 169 for such a torus. If the torus is tilted slightly so that the axis is no longer perpendicular to the orbital plane it then has four isolated exceptional points: the two extrema in the direction of the orbital plane's normal, along with corresponding saddle points opposite these extrema along minor diagonals. A sphere has two isolated exceptional points: the north and south poles (where the equator is defined to lie in the orbital plane). The significance of exceptional features is that they can have different dimensionality on the output CAD model than on the input CAD model. Typically, when offsetting convex solids outwards or concave solids inwards, the dimension of the feature is increased by the dimension of the path, up to a maximum final dimension of two. So for orbital paths which are curves (1D), exceptional points (0D) on the original model correspond to exceptional curves (1D) on the offset model, exceptional curves (1D) correspond to exceptional regions (2D), and exceptional regions (2D) correspond to exceptional regions (due to the 2D maximum). For filled orbital paths (2D regions), exceptional points, curves, and regions on the original model typically all correspond to exceptional regions on the offset model. In one embodiment, the new features are represented in the offset model by introducing new faces (for exceptional regions) or edges (for exceptional curves) corresponding to the zero-size limit of the orbital path. These faces will acquire a non-zero area when their edge geometry is replaced with the new, offset edge geometry. Conversely, when offsetting convex solids inwards or concave solids outwards, the dimension of features can be reduced. As used herein, the terms "original model" and "offset model" correspond to the input CAD model and the output CAD model, respectively, in one embodiment.

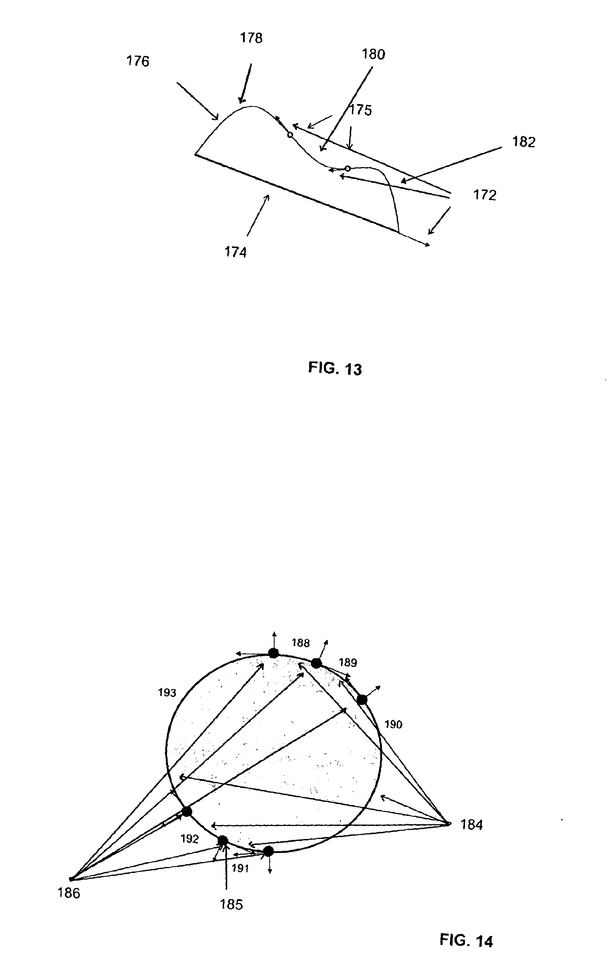

As will further be appreciated by those skilled in the art, silhouette features arise from region boundaries in the orbital path. In order to ensure that the mapping between a particular face on the input CAD model and a corresponding face on the output CAD model involves a single region, silhouetted edges (which split original faces) are inserted into the model along silhouette curves for which the surface normal is perpendicular to the tangent vector at any end-point of any region (the silhouette directions). Fig. 13 illustrates silhouette directions caused by inflection points and a linear region. In the illustrated example, the reference numeral 172 illustrates the silhouette directions, the reference numeral 174 illustrates a linear region, and the reference number 175 illustrates inflection points in the orbital path 176. The additional regions in the orbital path are illustrated by reference numerals 178, 180 and 182 respectively.

Accordingly, the input CAD model is segregated into vertical "strips" (bounded at the top and bottom by exceptional features) as illustrated, in cross-section, in Fig. 14. The strips 184 have the property that, if any point on the interior of a region corresponds to an interior point on a strip, then each point on the strip corresponds to at least one point in the region, where "corresponds", in this context, indicates that the tangent manifolds at the corresponding points are parallel. The silhouette edges are illustrated by the reference numeral 186. In particular, the reference numeral 185 illustrates a silhouette edge which corresponds to the linear region 174 in Fig. 13. Because it corresponds to a linear region, it will cause a (zero-area) silhouette face to be added along the edge.

Fig. 14 also illustrates the correspondence between strips and regions. Specifically, Fig. 14 illustrates strips 188, 189, 190, 191, 192, and 193 corresponding to regions 174, 178, 180 and 182 in Fig. 13. In particular, when using only a "parallel" directed correspondence relationship as discussed above (due to, for example, a filled path in figure 13), strip 188 corresponds to regions 178, 180 and 182, strip 189 corresponds to regions 178, 180 and 182, strip 190 corresponds to region 182, strip 191 corresponds to region 182, strip 192 corresponds to region 178 and strip 193 corresponds to region 178. Note that those strips corresponding to the concave region 180 correspond to a total of three regions each, while those strips not corresponding to a concave region only correspond to one strip each; this can be understood from "backtracking" of the identification between points on the cross-section of the strips with corresponding points on the path in regions where the convexity of the strip and the convexity of the path disagree. For the directed correspondence relation (which distinguishes inward from outward correspondence) discussed above, each point on the strip corresponds to one and only one point in the region, unless the region is linear. The directed correspondence relation is relevant in the case of filled planar paths, and it indicates that the projection of the surface normal of the original model into the orbital plane is parallel (as opposed to anti-parallel) to the normal to the curve in the direction away from the interior at the two points. Since parallel and anti-parallel branches typically do not contribute to the same offset strip, the parameterization of the original strip can be used to parameterize the offset strip.

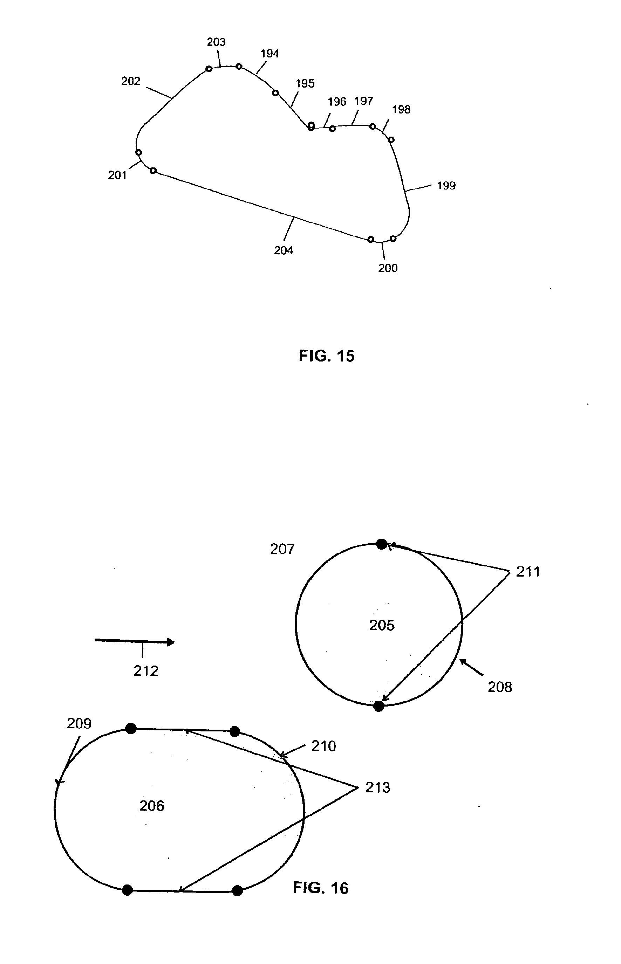

Fig. 15 illustrates a body resulting from sweeping the input CAD model illustrated in Fig. 14 along the (filled) path 176 illustrated in Fig. 13. In one embodiment, the boundary of the body is comprised of offset strips 194-203 and the silhouette face 204. Each of the offset strips 194-203 corresponds to a correspondence between a strip in Fig. 14 and a region in Fig. 13, while the silhouette face 204 corresponds to a correspondence between silhouette edge 185 in Fig. 14 and the linear region 174 in Fig. 13. In particular, the offset strip 194 is generated by the correspondence between strip 189 and region 178, the offset strip 195 is generated by the correspondence between strip 189 and region 180, the offset strip 196 is generated by the correspondence between strip 188 and region 180, the offset strip 197 is generated by the correspondence between strip 188 and region 182, the offset strip 198 is generated by the correspondence between strip 189 and region 182, the offset strip 199 is generated by the correspondence between strip 190 and region 182, the offset strip 200 is generated by the correspondence between strip 191 and region 182, the offset strip 201 is generated by the correspondence between strip 192 and region 178, the offset strip 202 is generated by the correspondence between strip 193 and region 178 and the offset strip 203 is generated by the correspondence between strip 188 and region 178. Again, these correspondences can be understood by thinking of moving an individual point along the path and looking for its corresponding point on the strips.

Fig. 16 illustrates a mapping of a strip on an original model into a strip on an offset model, in accordance with another embodiment of the present invention. Each strip 207 or 208 on the original model 205 can be mapped, through a particular region and orientation of the normal, into corresponding strips 209 and 210 on the offset model 206. The boundary of the offset model 206 can be thought of as being covered by mapped strips of the boundary of the original model 205, where a particular strip of the original model 205 maps to one or more strips of the offset model 206. In one embodiment, the strips are copied on the original model 205 so that the multiplicity of each strip matches the multiplicity of the mapping as illustrated in Fig. 16. Each copied strip on the original model 205 is then "one-to-one" mapped with a strip on the offset model 206.

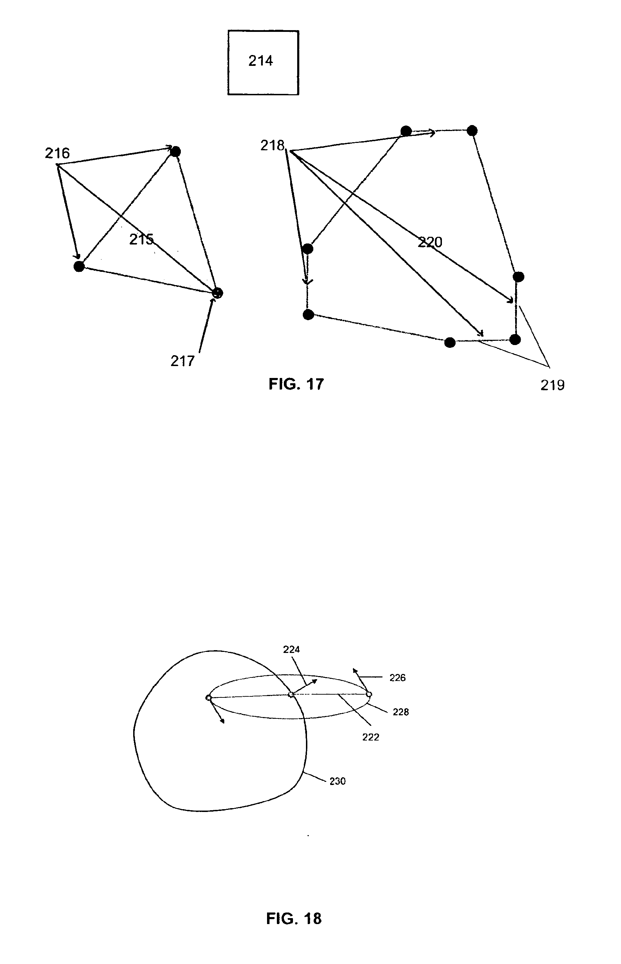

Note that the mapping of strips from the original model 205 into the offset model 206 may not entirely cover the offset model 206. Besides exceptional faces, which typically do not participate in the strip analysis, and faces arising from sharp features, there are also regions of the boundary of the offset model 206 corresponding to linear regions of the orbital path. The geometry of these regions corresponds to sweeping the silhouette curve in the silhouette direction. In one embodiment, such faces are represented by identifying silhouette edges 211 which are not already adjacent to a silhouette face 213 with the same silhouette direction 212. The edge 211 is replaced with the silhouette face 213 with the same silhouette direction 212, where the face 213 has a geometry corresponding to a sweep of the silhouette curve in the silhouette direction 212 as further illustrated in Fig. 16. Note that a particular edge may be replaced by multiple faces, if it corresponds to more than one silhouetted direction. For example, Fig. 17 illustrates a triangular (vertical) prism 215 and a square orbital path 214. The silhouette edges 216 are the non-exceptional edges of the triangle 215. One of these edges 217 is associated with two silhouette faces 219 on the offset model 220.

Although the various copies of strips of the original model cover the offset model's boundary, the adjacency relationship between strips in general may be scrambled. One way to manage this issue is to unstitch the model along all silhouette and exceptional edges and then re-stitch strips on the offset model during the topology repair phase as described below.

One aspect involved in parameterizing the offset surface boundary arises from the presence of exceptional points (and silhouette points, if any exist) on the boundary of the original model. An exceptional point on the original model's boundary is typically mapped into a curve (or a curve which bounds an exceptional region). If the surface in which the exceptional point is embedded has a radial parametric singularity at that point (e.g., like the singularity in latitude/longitude at the north pole of a sphere), then the angular coordinate θ may be used to parameterize the curve. When this is not the case, a single coordinate value on the original surface is typically mapped to an entire boundary curve of the offset surface, which one skilled in the art will recognize implies that the offset surface has a non-C0 discontinuity along said boundary. One way to address this issue is to cut a small disk out of the boundary of the original model and replace it with a face whose surface has an appropriate parametric singularity. One such surface is a periodic hermite B-spline patch which interpolates between the boundary of the disk and the exceptional point, and which approximates the original geometry in this region. If a replacement disk which matches the original surface geometry is desired, then this B-spline patch can be used to parameterize a procedural surface which replicates the original shape by, for example, using a perpendicular projection technique to project from a point on the B-spline patch onto the original surface to obtain a procedural surface, the value of whose shape function for a particular parameter value is determined by the result of the projection into the original surface.

### Specific embodiment of the operation of analyzing the input solid model

In a particular embodiment, the operation 126 of analyzing the input CAD model includes deriving a set of faces for the solid model of the tool shape corresponding to each face in the set of faces in the input CAD model by convoluting a subset of a geometry associated with the set of faces in the input solid model with a subset of the orbital path shape. Each point on each face of a subset of the set of faces in the solid model of the tool shape lies on a boundary of a particular Minkowski decomposition of the input CAD model with respect to the orbital path shape. Specifically, each point on the convolution of each face in the input solid model with the orbital path shape that lies on the boundary of the Minkowski decomposition is included in the set of faces corresponding to the solid model of the tool shape. A set of edges and vertices corresponding to each face in the input solid model are similarly derived.

In an exemplary set of operations, the operation 126 of analyzing the input CAD model is performed as follows:

Each face's surface is ensured to be at least G1 continuous everywhere by splitting non-G 1 faces along discontinuities.

For each face in the input CAD model, the set of all exceptional and/or silhouette points on the face's surface is determined. As used herein, an "exceptional point" refers to a point at which the surface normal is perpendicular to the plane of the path, and a "silhouette point" refers to a non-exceptional point at which the surface normal is perpendicular to a silhouette direction of the curve describing the path. In one embodiment, the set of exceptional and/or silhouette points include a collection of isolated exceptional and/or silhouette points, exceptional and/or silhouette curves, and/or two dimensional exceptional and/or silhouette regions. Note that exceptional curves and regions are geometrically planar, while silhouette regions are typically ruled.

Each two dimensional exceptional region in the input CAD model is replaced with a planar face.

The input CAD model is split by inserting one or more new edges along each exceptional or silhouette curve. When offsetting outwards, a small neighborhood around each convex exceptional point is replaced with a face whose surface is parameterized in radial coordinates, with the origin at the exceptional point, and with a vertex at the exceptional point. When offsetting inwards, as is typically the case when calculating an EDM electrode shape, such concave points are replaced. The geometry of the replacement face can either be an approximation to the original geometry it replaces in one embodiment or a procedurally defined surface that is coincident everywhere with the original geometry but has a different (radial) coordination, in another embodiment. An example of such an approximation may include a B-Spline approximation.

All edges according to the convexity of the body at each point along the edge are classified as "convex", "concave", "tangent" or "mixed" (including both convex and concave regions).

All mixed-convexity edges are split at each point where the convexity changes.

All exceptional and silhouette faces are identified. An exceptional face is a planar face whose normal points in an exceptional direction, while a silhouette face is a face whose normal is perpendicular at all points to a silhouette direction.

All "expanding" edges and vertices are identified. When offsetting outwards, convex edges and vertices are expanding unless, in the case of edges, they are adjacent to an exceptional or silhouette face. When shelling inwards, as it is typically the case when calculating an EDM electrode shape, concave edges and vertices are expanding unless, in the case of edges, they are adjacent to an exceptional or silhouette face.

All "contracting" edges and vertices are identified.

If any contracting edges or vertices exist and the user has requested a non-manufacturability notification, an indication of non-manufacturability of the model is notified to the user.

Each expanding, exceptional edge is replaced with a zero-area exceptional face, bounded by side-by-side copies of the edge and whose geometry is the exceptional plane in which the edge's geometry can be embedded. As used herein, an "exceptional edge" refers to an edge that runs along an exceptional curve.

Each expanding or tangent silhouette edge corresponding to a linear region is replaced with a zero-area silhouette face, bounded by side-by-side copies of the edge and whose geometry is a linear sweep of the edge geometry in the silhouette (linear region) direction, unless the edge is already adjacent to such a face. Note that, for expanding silhouette edges, more than one such silhouette face may be typically inserted due to compatibility with multiple silhouette directions corresponding to multiple linear regions. If this is the case, then the faces may be ordered so that the normal direction rotates monotonically.

Each expanding non-silhouette and non-exceptional edge is replaced with a zero-area face, bounded by side-by-side copies of the edge and whose geometry is that of a zero-radius fillet along the edge.

Each expanding exceptional point is replaced with a zero-area exceptional face, bounded by an infinitesimal circular edge and whose geometry is the exceptional plane corresponding to the point's surface normal.

If there are silhouette edges, the model is unstitched along these edges.

Strips on the model are identified as collections of faces bounded by the unstitched silhouette edges and edges adjacent to the exceptional faces.

For each strip, any edges or vertices connecting the strip to the rest of the model are identified, and the model is unstitched along these edges and vertices. Note that these edges will be exceptional, since any other edges in the strip's boundary will have already been unstitched.

For each strip with non-silhouette faces, any non-silhouette, non-exceptional test point is identified, and the corresponding points on the curve describing the path are determined. For a path which is a curve, the corresponding points are those associated with a unit (tangent) vector perpendicular to both the orbital plane and the surface normal at the test point. For a path which is a region, a further constraint that the 2D normal to the region is parallel to the projection of the surface normal vector into the orbital plane is imposed on the set of corresponding points when offsetting outward. When offsetting inwards the vectors are anti-parallel. For each corresponding point, the region on the curve describing the path that contains the point is determined. In addition, the point is characterized as to whether the outward 2D normal is parallel or anti-parallel to the projection of the surface normal into the plane of the path. For regions, the outward 2D normal is that of the region. For curves which are the boundary of a 2D region, the outward 2D normal is that of the region. For curves which are not the boundary of a 2D region, the outward 2D normal is arbitrarily defined as the cross product of the normal to the plane of the path with the tangent along the curve, where the direction of the curve is consistent but arbitrary. This region of the curve along with the characterization of the 2D normal is referred to as a "branch", in one embodiment.

For each strip consisting of silhouette faces, a similar analysis is performed. Each strip will correspond to some set of inflection points and/or linear regions; for each linear region an arbitrary corresponding point within that region should be chosen in order to characterize the region. These inflection points and/or linear regions, along with their characterizations of the 2D normal are similarly referred to as "branches", in one embodiment.

For each strip, and for each branch corresponding to said strip beyond the first, the strip is copied and each copy of the strip, including the original, is then associated with a different branch.

### Operation of creating a new geometry

An operation to create a new geometry is performed (block 128). The new geometry is defined, in one embodiment, by convoluting the geometry of a particular strip with that of a corresponding particular branch. This is effected by, for each point on the strip, adding a displacement determined by finding the corresponding point on the branch and treating the position of the point on the branch as a displacement. A capability in CAD modelers is support for "procedural" surfaces, where the shape function of a particular surface may depend on the shape functions of other surfaces or curves, called "progenitors". For example, the shape function of a rolling-ball fillet surface typically depends on the shape functions of the support faces adjacent to the fillet. In constant offsetting, the offset surface shape is defined by displacing the original surface location by distance D in the direction of the surface normal as follows: C(u,v) = A(u,v) + D*N_A(u,v), where C(u,v) is the shape function describing the offset surface, A(u,v) is the shape function describing the original surface, and N_A(u,v) is the unit normal vector to the surface at parameter values (u,v). Note that D*N_A is the displacement vector to a point on the sphere corresponding to the path which generates the offset surface C when the original surface A is translated along it. Also note that positive D indicates offsetting outward while negative D represents offsetting inward. In the case of EDM with a non-spherical path, the difference between original and offset surface locations is a displacement vector corresponding to a point on the path whose tangent space is perpendicular to N_A(u,v): C(u,v) = A(u,v) + B_i(N_A(u,v); u,v) where C, A, and N_A are defined as previously, while B_i is a continuous displacement function which maps surface normals of A into points on the orbital path such that the tangent manifold at such points on the orbital path are parallel to the tangent manifolds on A to which the surface normals are orthogonal. The subscript "i" is intended to indicate that a particular orbital path shape can generate multiple displacement functions B_i(N(u,v); u, v), while the additional arguments u,v indicate that (for continuity reasons) the particular branch of the orbital path shape used to form a particular B_i may depend on u and v. Fig. 18 illustrates performing offsetting operations to various branches of an orbital path shape. In particular, Fig. 18 illustrates the displacement vector 222, the projected surface normal 224, the tangent to the path 226, the path 228 and the original body 230 corresponding to an exemplary operation of offsetting a particular point on the original body to various branches of an orbital path.

The multiple displacement functions correspond to the various displacements between a particular strip on the original surface (see discussion above) and the corresponding strip(s) on the offset surface, namely the multiple branches associated with a strip. In one embodiment, the surface shape function C(u,v) can be represented in a CAD model which permits procedural surfaces.

As will be appreciated by those skilled in the art, CAD modelers typically define surfaces to be mathematically well-behaved (e.g., continuous, not self-intersecting, etc.) within some uv rectangle. CAD modelers also typically extend surfaces beyond their original uv rectangle, for example when performing CAD offsetting or filleting operations. If such a parametric rectangle contains exceptional or silhouette curves, then the displacement function B_i(N(u,v); u, v) is typically associated with different branches in different regions of the uv rectangle, with the change between branches occurring along exceptional or silhouette curves. In one embodiment, a "branch switcher" object is introduced for each surface in the offset model, and a calibration point within the face corresponding to the surface is determined. At the calibration point (u0, v0), B_i is chosen to lie on a specific branch, and this choice of branch is extended away from (u0, v0) by imposing G0 continuity of B_i within the entire parametric rectangle. For a simple path such as a circle, for example, there are typically two branches: "outward" (offsetting in a direction parallel to the projected normal) and "inward" (offsetting in an anti-parallel direction). If offsetting outward, then the "outward" branch is chosen at the test point and all points reachable from the test point without crossing an exceptional curve. All points reachable by crossing a single exceptional curve (with the assumption of absence of a higher-order root) typically use the "inward" branch. Points reachable by crossing an even number of exceptional curves typically use the "outward" branch, and those reachable by an odd number of crossings typically use the "inward" branch. The ambiguity in direction between "outward" and "inward" for points exactly on an exceptional curve can be resolved by specifying a direction along the curve, determined by the requirement of continuity. B_i corresponds to flipping the "outward" and "inward" assignments of the various regions (and directions along the exceptional curves).

In another example, for a circular path and a (horizontal) cylinder whose axis is parallel to the orbital plane, the exceptional curves are straight iso-lines separated in parameter space by ½ period. These two lines separate the cylinder into two (1/2-cylinder) regions. One of the B_i's use the "outward" branch in the first region and the "inward" branch in the second, while the other B_i uses the "inward" branch in the first region and the "outward" branch in the second.

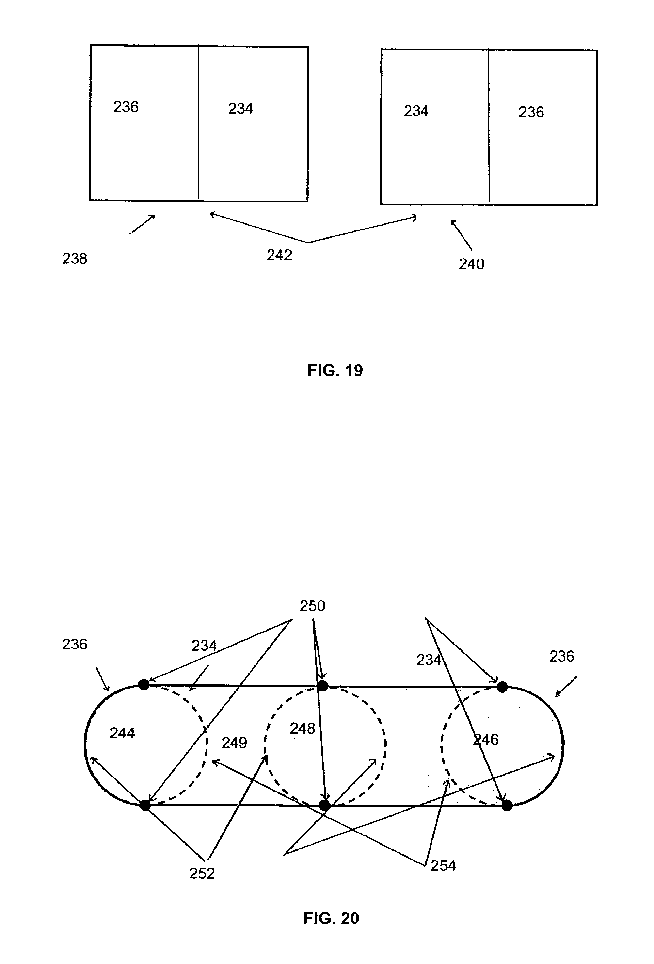

Figure 19 illustrates, in UV space, a pair of branch switchers for a pair of ½ cylinder faces, one for each region. Each UV rectangle, corresponding to the UV space of a full cylinder, switches between an inward branch 234 and an outward branch 236 in such a way as to maintain continuity for the entire (full cylinder) surface of which the corresponding face is a subset. The two UV rectangles are illustrated by the reference numeral 242.

The two branch switchers 238 and 240 correspond to translating the cylinder 248 to the left 244 and to the right 246, respectively, within the orbital plane, where the left and right directions are defined as perpendicular to the cylinder's axis as illustrated in Fig. 20. Reference numeral 250 indicates an exceptional edge on the cylinder, reference numeral 252 illustrates a face on the cylinder 248 and the corresponding offset face on the translated cylinder 244, and reference numeral 254 illustrates portions of the offset surfaces 244 and 246 which fall on the interior of the result body 249 and so are outside the boundary of the faces defining the boundary of the result body 249. Note that both of these regions 254 correspond to the inward branches 234 in Figure 19. In addition to surface geometry corresponding to faces, solid modelers typically have curve geometry corresponding to edges and point geometry corresponding to vertices, and this additional geometry should also be offset. One technique for obtaining the geometry for edges (or vertices) in an offset model is to represent the original geometry as being embedded in one of the original surfaces corresponding to the faces adjacent to the original edge, resulting in a curve (or point) in the surface parameter space (u,v). The offset curve (or point) geometry then corresponds to the same uv-curve (or point) on the offset surface. Special procedural geometry for the offset curves can be implemented, or such embedded geometry types may be included in the modeler. The offset point geometry is an xyz position, which a CAD modeler can typically represent without modification.

### Specific embodiment of the operation of creating a new geometry

In a particular embodiment, the operation of creating a new geometry (block 128) is performed as follows.

For each non-exceptional, non-silhouette face on each strip in the model, a new, continuous, surface geometry is defined where the location of each point is calculated as the sum of its original position on the surface plus a displacement defined by a corresponding point on one of the branches associated with the original position. This operation can be viewed as identifying a non-exceptional reference point on the interior of the face and the corresponding branch of the curve which describes the path. The new surface geometry corresponding to the reference point is defined to be the location of the test point translated by the displacement associated with the test point on its strip's branch. All exceptional and silhouette curves in the original surface corresponding to the face may then be determined. These curves partition the original surface into disjoint regions. For each disjoint region, a branch based on the requirement that the new surface be G0 continuous is chosen. In one embodiment, a surface object is created which manages the branch classification for each point on the surface and whose evaluator corresponds to adding a displacement from the appropriate branch to the position on the original surface. Note that, for combinations of path and surface shapes of reduced complexity, the shape of the offset geometry may be representable in the modeler. In such a case, the appropriate surface may be created and used instead of using the procedural offsetting mechanism. For example, for a linear path curve, the offset surface is typically a translation of the original surface. For circular path curves, spherical and toroidal original surfaces (including self-intersecting "vortex", "lemon" and "apple" tori which have major radius equal to or less than the minor radius) are typically offset into spheres or tori, horizontal cylinders (axis in orbital plane) are typically offset to a translated cylinder and vertical cylinders (axis perpendicular to orbital plane) are typically offset to a vertical cylinder with different radius.

For each silhouette face on each strip in the model, a new surface geometry is calculated by translating the original geometry (a linear sweep in the silhouette direction) by a displacement defined by a point on one of the branches associated with that surface position. For silhouette directions corresponding to a linear region of the curve, this translation may typically be performed using any point in the linear region, since the silhouette geometry is typically invariant under translations in the silhouette direction.

Geometry adjustment is typically not performed for exceptional faces, since their (planar) geometry is translation invariant in the direction of orbital motion. The extent of the faces may change, however, due to adjustment in the geometry of the bounding edges and vertices.

For each edge adjacent to at least one non-exceptional, non-silhouette face, a new geometric shape is calculated by projecting the edge's curve into an adjacent non-exceptional, non-silhouette surface and displacing the position of each point on the curve by the displacement of the projected point on the surface and a new curve object is created.

For each vertex adjacent to at least one non-exceptional, non-silhoutte face, a new position is calculated by projecting the vertex's position into an adjacent non-exceptional, non-silhouette face's surface and displacing the vertex's position by the displacement of the projected point on the surface. A new vertex position object is then created.

### Operation of replacing the original geometry with the new geometry

An operation to replace the original geometry with the new geometry is then performed. (Block 130).

After a new offset geometry has been calculated, for every (copy of) every face, edge, and vertex in the original model as discussed above, the geometry of each face, edge, and vertex is replaced with the corresponding offset geometry. That is, for each new surface, curve, or vertex position, the geometry of the corresponding face, edge, or vertex is replaced with the new geometry. In certain embodiments, the new geometry is typically procedural, but in some special configurations of orbital path and original surface geometry, the offset geometry may be a shape that can be represented in a less complex manner within the CAD modeler.

### Operation of repairing the topology

An operation to repair the topology is performed (block 132). After replacing the geometry, the topology of the offset model (i.e., the solid model of the tool shape) is repaired. In some instances, the repair operations can be viewed as inverse operations for performing modifications of the original model. Implementing the repair operation can be viewed as an inverse of the analyzing operation 124 (discussed above), such as for example, by comparing the step of copying faces in the model during the analyzing operation with the operation of removing coincident copies of faces during the topology repair step. If the analyzing step of an initial, outward offset adds topology to the model (e.g. additional faces), the post-analysis topology repair operation during a subsequent, identical, inward offset will typically remove them. In one embodiment, the operation of repairing the topology (block 132) is performed as follows.

Back-to-back regions of coincident exceptional or silhouette faces are detected, and the back-to-back regions are removed. This may be viewed as undoing the expansion of exceptional regions that are created while adjusting the geometry of edges bordering the exceptional edges.

Faces and edges which are of zero area, (i.e., geometrically corresponding to an edge or vertex) are detected and replaced with the corresponding edge or vertex. This may be viewed as an undoing operation where a zero-area face or edge is inserted to replace, for example, an exceptional, silhouette, or sharp edge or vertex. Such faces may be common in EDM electrode shape calculations, since they correspond to sharp edges or vertices in the electrode shape.

The adjacent strips are stitched together along their free edges. This operation may be viewed as undoing the unstitching performed which decomposed the original model into strips.

Coincident faces, edges, and vertices are detected, and duplicates are removed from the model. In one example, this can be viewed as undoing the operation of copying strips, as disclosed above.

A check to determine if the solid model of the tool shape includes self-intersections is then performed (block 134). The self-intersections imply that a point that is locally on the boundary of the solid model is on the interior of the offset of some other (non-local) region of the model. CAD offsetting operations can be used to determine self-intersections in the naive boundary of the offset boundary and to remove these self-intersections.

If self-intersections are found, the user is notified that the part is not manufacturable, and the offsetting operation can either fail or proceed by repairing the self-intersection by removing those pieces of the boundary which lie on the interior of the offset model (Block 136). In other words, such self-intersections indicate that there is no electrode shape which, when translated along the orbital path, can burn a cavity of the desired shape. In certain embodiments, the self-intersection detection can also be performed as an earlier operation in the process. For example, when the surface geometry associated with the offset of a particular face is being constructed, this geometry can be examined for self-intersections. Similarly, "contracting" edges (where the edge is in the interior of the model after an infinitesimal offset) can indicate self-intersections in the offset model's boundary. Note that edges which are adjacent to silhouette or exceptional faces are typically not contracting, since the offsetting operation typically moves the edge within the face.

An operation indicating cleanup and success is then performed (block 138). As a result of the operations (120-138) discussed above, an output CAD model representing a solid model of the tool shape is produced. As a final stage, the output model can be further processed using a plurality of solid modeling (CAD) operations, such as, for example, by taking its Boolean complement (e.g., to obtain a model of the electrode shape) or adding a base material (e.g., clamping fixtures) outside the region which will be machined to allow installation of the electrode within the EDM machine, after which success can be signaled. In one embodiment, the model may be further processed in standard ways such as by compensating the model for the EDM spark gap.

A practitioner of ordinary skill in the art requires no additional explanation in developing the embodiments described herein, but may find some helpful guidance regarding computing orbital path shapes and transforming shapes using CAD applications in Gang Wang, Yan Shan, "Compensation of electrode orbiting in electrical discharge machining based on non-uniform offsetting", International Journal of Machine Tools & Manufacture 45 (2005) 1628-1634, Martin Peternell, Tibor Steiner: "Minkowski sum boundary surfaces of 3D-objects", Graphical Models 69(3-4): 180-190 (2007), X.M.Ding, J.Y.H. Fuh, and K.S. Lee: "Computer aided EDM electrode design", Computers & Industrial Engineering 42(2-4) 259-269 (2002), Gasparraj, U.S. Patent Publication No. 2007/0239311 A1, entitled, "A method for Under-sizing Electrodes for Polygonal Orbit Electric Discharge Machining", Stallings et al., US Patent No. 6,941,251 B1, entitled, "Method for Transforming CAD Model Using General Function Composition Mechanism", the disclosures of which are hereby incorporated by reference in their entirety.

An embodiment of the present invention relates to a computer storage product with a computer-readable medium having computer code thereon for performing various computer-implemented operations. The media and computer code may be those specially designed and constructed for the purposes of the present invention, or they may be of the kind well known and available to those having skill in the computer software arts. Examples of computer-readable media include, but are not limited to: magnetic media such as hard disks, floppy disks, and magnetic tape; optical media such as CD-ROMs, DVDs and holographic devices; magneto-optical media; and hardware devices that are specially configured to store and execute program code, such as application-specific integrated circuits ("ASICs"), programmable logic devices ("PLDs") and ROM and RAM devices. Examples of computer code include machine code, such as produced by a compiler, and files containing higher-level code that are executed by a computer using an interpreter. For example, an embodiment of the invention may be implemented using Java, C++, or other object-oriented programming language and development tools. Another embodiment of the invention may be implemented in hardwired circuitry in place of, or in combination with, machine-executable software instructions.

The foregoing description, for purposes of explanation, used specific nomenclature to provide a thorough understanding of the invention. However, it will be apparent to one skilled in the art that certain details are not required in order to practice the invention. Thus, the foregoing descriptions of specific embodiments of the invention are presented for purposes of illustration and description. They are not intended to be exhaustive or to limit the invention to the precise forms disclosed; obviously, many modifications and variations are possible in view of the above teachings. The embodiments were chosen and described in order to best explain the principles of the invention and its practical applications, they thereby enable others skilled in the art to best utilize the invention and various embodiments with various modifications as are suited to the particular use contemplated. It is intended that the following claims and their equivalents define the scope of the invention.

## Claims

1. A computer readable storage medium comprising executable instructions to:
obtain an orbital path shape, wherein each point on the orbital path shape represents a displacement of a tool shape when the tool shape is moved along the orbital path shape, and wherein the tool shape, when moved along the orbital path shape, sweeps out a desired cavity shape;
obtain an input solid model corresponding to the desired cavity shape to be swept out;
derive a set of faces for a solid model of the tool shape based on the orbital path shape and a set of faces, a set of edges and a set of vertices corresponding to the input solid model; and
combine a subset of the set of faces derived for the solid model of the tool shape to generate the solid model of the tool shape, wherein the tool shape corresponds to a Minkowski decomposition of the input solid model with respect to the orbital path shape.

2. The computer readable storage medium of claim 1, wherein at least a subset of the set of faces is derived for the solid model of the tool shape using variable offset surface geometry defined by a solid modeler.

3. The computer readable storage medium of claim 1, wherein the solid model of the tool shape represents a CAD model of an electrode shape.

4. The computer readable storage medium of claim 1, further comprising executable instructions to derive a subset of the set of faces for the solid model of the tool shape corresponding to a subset of the set of faces in the input solid model by convoluting a subset of the geometry associated with the set of faces in the input solid model with a subset of the orbital path shape.

5. The computer readable storage medium of claim 1, further comprising executable instructions to derive a subset of the set of faces for the solid model of the tool shape corresponding to a subset of the set of edges in the input solid model by convoluting a subset of the geometry associated with the set of edges in the input solid model with a subset of the orbital path shape.

6. The computer readable storage medium of claim 1, further comprising executable instructions to derive a subset of the set of faces for the solid model of the tool shape corresponding to a subset of the set of vertices in the input solid model by convoluting a subset of the geometry associated with the set of vertices in the input solid model with a subset of the orbital path shape.

7. The computer readable storage medium of any one of claims 4 to 6, wherein each point on the convolution of each face in the input solid model with the orbital path shape that lies on the boundary of the Minkowski decomposition is included in the set of faces corresponding to the solid model of the tool shape.

8. The computer readable storage medium of claim 1, wherein the executable instructions to obtain the orbital path shape comprise executable instructions to analyze the orbital path shape to identify regions in the orbital path shape that correspond to a set of exceptional features and a set of silhouette features on the boundary of the input solid model.

9. The computer readable storage medium of claim 8, further comprising executable instructions to use the set of exceptional features and the set of silhouette features to partition the boundary of the input solid model into one or more strips, wherein the strips correspond to the regions in the orbital path shape.

10. The computer readable storage medium of claim 9, wherein the executable instructions to generate the solid model of the tool shape further comprise executable instructions to map the strips in the input solid model to corresponding strips in the solid model of the tool shape.

11. The computer readable storage medium of claim 8, further comprising executable instructions to identify exceptional points in the input solid model and replace the exceptional points with corresponding parameterized faces.

12. The computer readable storage medium of claim 1, further comprising executable instructions to repair the solid model of the tool shape.

13. The computer readable storage medium of claim 12, wherein the executable instructions to repair the solid model of the tool shape comprise executable instructions to detect and remove sets of coincident exceptional faces and sets of coincident silhouette faces from the solid model of the tool shape.

14. The computer readable storage medium of claim 12, wherein the executable instructions to repair the solid model of the tool shape comprise executable instructions to detect a set of zero-area faces and zero-length edges in the solid model of the tool shape and replace the set of zero-area faces and zero-length edges with a set of edges and vertices.

15. The computer readable storage medium of claim 12, wherein the executable instructions to repair the solid model of the tool shape comprise executable instructions to detect and remove duplicates within sets of coincident faces, coincident edges and coincident vertices from the solid model of the tool shape.
